# EUROPÄISCHE PATENTSCHRIFT

(11) **EP 3 336 911 B1**
(45) Veröffentlichungstag und Bekanntmachung des Hinweises auf die Patenterteilung: **10.07.2019**
(21) Anmeldenummer: 17200181.0
(22) Anmeldetag: 06.11.2017
(51) Int. Cl.: H01L 41/047, G01L 1/16, H01L 41/083, H01L 41/113, H01L 41/277, H01L 41/293

(54) **MESSELEMENTSTAPEL ZUM MESSEN VON KRÄFTEN ODER DRÜCKEN UND VERFAHREN ZUR HERSTELLUNG EINES DERARTIGEN MESSELEMENTSTAPELS**
MEASURING ELEMENT STACK FOR MEASURING FORCES OR PRESSURES AND METHOD FOR PRODUCING SUCH A MEASURING ELEMENT STACK
EMPILEMENT D'ÉLÉMENT DE MESURE PERMETTANT DE MESURER LES PUISSANCES OU LES PRESSIONS ET PROCÉDÉ DE FABRICATION D'UN TEL EMPILEMENT D'ÉLÉMENT DE MESURE

(30) Priorität: 13.12.2016 AT 511292016
(43) Veröffentlichungstag der Anmeldung: 20.06.2018
(73) Patentinhaber: Piezocryst Advanced Sensorics GmbH, 8020 Graz (AT)
(72) Erfinder: STRMSEK, Robert, 2327 Race (SI); BAUMGARTNER, Martin, 8522 Gross St. Florian (AT); KROEGER, Dietmar, 8010 Graz (AT)
(74) Vertreter: Babeluk, Michael

(56) Entgegenhaltungen:
- EP-A2- 2 878 939
- WO-A1-2005/026678
- DE-A1- 3 838 014

## Beschreibung

Die Erfindung betrifft einen Messelementstapel zum Messen von Kräften oder Drücken aus mehreren piezoelektrischen Kristallelementen, die unter Nutzung des transversalen Piezoeffektes mit jeweils entgegengerichteter elektrischer Polarisation gestapelt sind, die gegenüberliegende erste und zweite Stirnflächen sowie gegenüberliegende dritte und vierte Stirnflächen und parallele Seitenflächen mit Ableitelektroden aufweisen, wobei an den gegenüberliegenden ersten und zweiten Stirnflächen erste und zweite stirnseitige Elektroden angeordnet sind. Weiters betrifft die Erfindung ein Verfahren zur Herstellung eines derartigen Messelementstapels.

Aus der WO 2005/026678 A1 ist in diesem Zusammenhang ein Messelementstapel bekannt geworden, der aus mehreren, nebeneinander angeordneten, piezoelektrischen Kristallelementen besteht, bei welchen der Transversaleffekt genutzt wird. Die Kristallelemente weisen eine Dicke von ca. 0,5 mm auf und sind als Platten oder flache Quader ausgebildet. Alle sich unter Krafteinfluss elektrisch aufladenden Seitenflächen sind mit einer seitlichen Elektrode beschichtet. Abgesehen von den beiden äußeren, seitlichen Elektroden des Stapels verbinden die anderen, mittleren Ableitelektroden jeweils zwei benachbarte Kristallelemente fest miteinander. Die Verbindung durch die Ableitelektrode ist derart ausgebildet, dass sie sich unter der maximalen Last, welcher der Messelementstapel ausgesetzt werden soll und im gesamten, für den Stapel zugelassenen Temperaturbereich, nicht löst. Diese Verbindung kann beispielsweise mittels Bonden, Löten oder Thermokompression erreicht werden. Wichtig ist allerdings, dass zwei benachbarte Kristallelemente jeweils mit entgegengesetzten Polarisationsrichtungen angeordnet sind.

Zur Ladungsabnahme werden die unter Lasteinfluss Kraft aufnehmenden Stirnflächen der Kristallelemente ebenfalls mit einem elektrisch leitenden Material beschichtet. Dadurch entstehen die stirnflächigen Elektroden. Da die seitlichen Ableitelektroden während einer Messung jeweils alternierend entgegengesetzte Ladungen sammeln, ist darauf zu achten, dass benachbarte Ableitelektroden isoliert voneinander ausgeführt sind. Zu diesem Zweck werden die seitlichen Ableitelektroden alternierend von der oberen bzw. von der unteren stirnflächigen Elektrode getrennt.

Dies geschieht bei der WO 2005/026678 A1 durch das Anbringen einer kerbenartigen Fase am Übergang von der Seitenfläche zur Stirnfläche. Dadurch sammeln sich unter Lasteinfluss jeweils positive Ladungen auf der einen Stirnfläche und negative Ladungen auf der gegenüberliegenden Stirnfläche des Messelementstapels. An diesen, jeweils durch die kerbenartigen Fasen getrennten, stirnflächigen Elektroden kann die Ladungsabnahme von allen seitlichen Ableitelektroden erfolgen.

Ein ähnlicher Messelementstapel ist aus der EP 2 878 939 A bekannt. Nachteilig bei diesem bekannten Konzept sind insbesondere die kerbartigen Fasen an den krafteinleitenden Stirnflächen der einzelnen Kristallelemente, die eine Materialschwächung darstellen, die bei hohen Temperaturen und/oder hoher Last bzw. raschem Lastwechsel zu einem Bruch einzelner Kristallelemente in diesem Bereich führen kann.

Ein weiterer Nachteil besteht darin, dass das Herstellungsverfahren relativ aufwendig ist.

Aufgabe der Erfindung ist es, einen Messelementstapel zum Messen von Kräften oder Drücken bestehend aus mehreren piezoelektrischen Kristallelementen der eingangs beschriebenen Art derart zu verbessern, dass die oben genannten Nachteile vermieden werden und ein hochtemperaturfester mit hohen Kräften und Drücken belastbarer Messelementstapel realisierbar ist. Eine weitere Aufgabe besteht darin, ein möglichst einfaches Verfahren zur Herstellung eines derartigen Messelementstapels zu beschreiben.

Erfindungsgemäß wird dies dadurch erreicht, dass die gegenüberliegenden dritten und vierten Stirnflächen, die auf den Seitenflächen im Wesentlichen normal stehen, als planparallele Krafteinleitflächen ausgebildet sind, wobei jede Ableitelektrode einen elektrisch isolierenden Bereich aufweist.

Erfindungsgemäß sind somit die Ladungsableitung und die Krafteinleitung am Messelementstapel völlig entkoppelt und erfolgen über unterschiedliche jeweils gegenüberliegende Außenflächen des Stapels, die für den jeweiligen Zweck optimal und unabhängig voneinander konditioniert werden können.

Ein erfindungsgemäßes Verfahren zur Herstellung eines Messelementstapels zum Messen von Kräften oder Drücken aus mehreren piezoelektrischen Kristallelementen, die unter Nutzung des transversalen Piezoeffektes mit jeweils entgegengerichteter elektrischer Polarisation gestapelt werden, ist durch folgende Schritte gekennzeichnet:
a. Bereitstellen von im Wesentlichen quaderförmigen Kristallelementen mit parallelen Seitenflächen, gegenüberliegenden ersten und zweiten Stirnflächen sowie gegenüberliegenden dritten und vierten Stirnflächen mit Rohabmessungen;
b. Aufbringen von Ableitelektroden auf beide Seitenflächen, wobei jeweils elektrisch isolierende Bereiche im Bereich einer der ersten und zweiten Stirnflächen hergestellt werden, und wobei die beiden isolierenden Bereiche unterschiedlichen ersten und zweiten Stirnflächen des Kristallelements zugeordnet sind;
c. Aneinanderreihen mehrerer Kristallelemente zu einem Messelementstapel, so dass die isolierenden Bereiche benachbarter Ableitelektroden aneinander anliegen;
d. Fixierung der Kristallelemente durch eine von außen angreifende Spanneinrichtung;
e. jeweils gemeinsame Bearbeitung der dritten und der vierten Stirnflächen der Kristallelemente in der Spanneinrichtung durch Schleifen und oder Läppen zur Abtragung von Längenunterschieden einzelner Kristallelemente und zur Herstellung von zwei gegenüberliegenden, im Wesentlichen planparallelen Auflageflächen zur Krafteinleitung;
f. Aufbringen einer ersten, stirnseitigen Elektrode auf eine durch die ersten Stirnflächen gebildete, erste Auflagefläche und einer zweiten stirnseitigen Elektrode auf eine durch die zweiten Stirnflächen gebildete, zweite Auflagefläche zur Ladungsableitung; sowie
g. Entfernen der Spanneinrichtung vom Messelementstapel.

Gemäß einer ersten Ausführungsvariante der Erfindung ist jede Ableitelektrode durch den elektrisch isolierenden Bereich in eine kleinere, an eine der beiden Stirnflächen angrenzende Randelektrode und eine größere Hauptelektrode unterteilt, wobei eine der Hauptelektroden des Kristallelements an dessen erste Stirnfläche angrenzt und die erste stirnseitige Elektrode kontaktiert und die andere Hauptelektrode an dessen zweite Stirnfläche angrenzt und die zweite stirnseitige Elektrode kontaktiert und wobei die Randelektroden benachbarter Ableitelektroden aneinander anliegen.

Gemäß einer zweiten Ausführungsvariante der Erfindung ist der elektrisch isolierenden Bereich jeder Ableitelektrode beispielsweise in Form einer randseitigen Fase oder Ausnehmung vorgesehen, wobei ein isolierender Bereich des Kristallelements an dessen erste Stirnfläche und der andere isolierende Bereich an dessen zweite Stirnfläche angrenzt und die isolierenden Bereiche benachbarter Ableitelektroden im Messelementstapel einander zugekehrt angeordnet sind.

Die Erfindung wird im Folgenden anhand von Ausführungsbeispielen näher erläutert. Es zeigen:
- Fig. 1: einen erfindungsgemäßen Messelementstapel zum Messen von Kräften oder Drücken bestehend aus mehreren piezoelektrischen Kristallelementen in einer dreidimensionalen Ansicht;
- Fig. 2: den Messelementstapel gemäß Fig. 1 in einer Draufsicht;
- Fig. 3: eine Ausführungsvariante eines erfindungsgemäßen Messelementstapels in einer dreidimensionalen Ansicht;
- Fig. 4: eine weitere Ausführungsvariante eines erfindungsgemäßen Messelementstapels in einer dreidimensionalen Ansicht;
- Fig. 5: eine Variante des Messelementstapels gemäß Fig. 2 in einer Draufsicht; sowie
- Fig. 6: eine Einbausituation des Messelementstapels gemäß Fig. 1 in einen Drucksensor in einer dreidimensionalen Ansicht.

Funktionsgleiche Teile sind in den Ausführungsvarianten mit gleichen Bezugszeichen versehen.

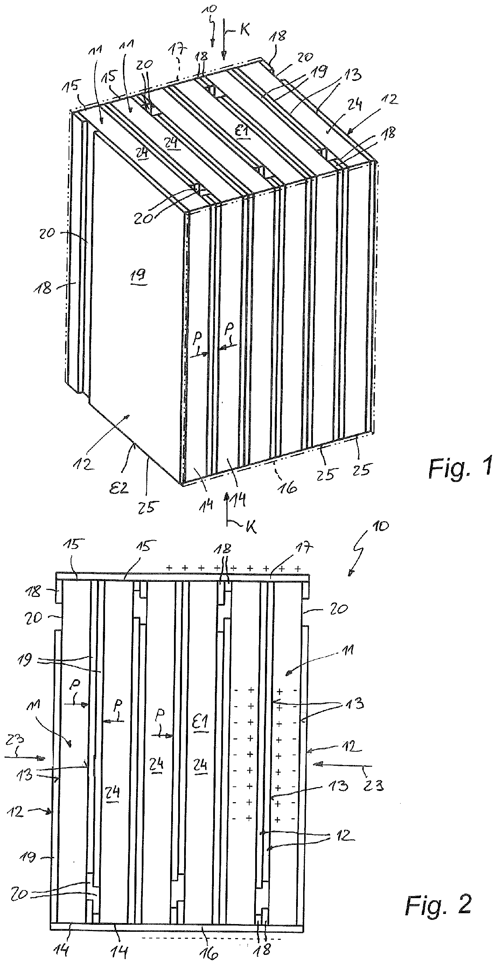

Der Messelementstapel 10 gemäß Fig. 1 und Fig. 2 besteht aus mehreren quader- bzw. plattenförmigen, piezoelektrischen Kristallelementen 11, die unter Nutzung des transversalen Piezoeffektes mit jeweils entgegengerichteter, elektrischer Polarisation P gestapelt sind und deren unter Krafteinfluss elektrische Ladungen generierende Seitenflächen 13 Ableitelektroden 12 aufweisen. An gegenüberliegenden, ersten und zweiten Stirnflächen 14, 15, die auf die Seitenflächen 13 im Wesentlichen normal stehen, sind erste und zweite stirnseitige Elektroden 16, 17 angeordnet (in Fig. 1 strichpunktiert dargestellt), die jeweils gegenüberliegende Seitenflächen des Messelementstapels 10 abdecken.

Die Krafteinleitung (siehe Pfeile K) erfolgt beim erfindungsgemäßen Messelementstapel 10 völlig unabhängig vom Ort der Ladungsableitung über die gegenüberliegenden dritten und vierten Stirnflächen 24, 25 der Kristallelemente 11, die auf die Seitenflächen 13 im Wesentlichen normal stehen und als planparallele Krafteinleitflächen ε1, ε2 ausgebildet sind. In der Draufsicht gemäß Fig. 2 erfolgt die Krafteinleitung normal auf die Abbildungsebene.

Die Schichtdicke der Ableitelektroden 12 und der stirnseitigen Elektroden 16, 17 ist im Vergleich zu den Abmessungen der Kristallelemente 11 überhöht dargestellt, um Details besser sichtbar zu machen.

Die Ableitelektroden 12 sind durch elektrisch isolierende Bereiche 20 asymmetrisch jeweils in eine kleinere, an eine der beiden Stirnflächen 14, 15 angrenzende Randelektrode 18 und eine größere Hauptelektrode 19 unterteilt, wobei eine der Hauptelektroden 19 des Kristallelements 11 an dessen erste Stirnfläche 14 angrenzt und die erste stirnseitige Elektrode 16 kontaktiert und die andere Hauptelektrode 19 an dessen zweite Stirnfläche 15 angrenzt und die zweite stirnseitige Elektrode 17 kontaktiert.

Bei der Erfindung wird darauf geachtet, dass die Randelektrode 18 und der elektrisch isolierende Bereich 20 zusammen weniger als 20%, bevorzugt weniger als 5% bis 10%, der Seitenfläche 13 des Kristallelements 11 beanspruchen, um den nicht zum Messsignal beitragenden Randbereich des Kristallelements 11, in welchem sich die Ladungen kompensieren, klein zu halten.

Die ersten Stirnflächen 14 der gestapelten Kristallelemente 11 und die daran angrenzenden Rand- und Hauptelektroden 18, 19 aller Kristallelemente 11 des Messelementstapels 10 bilden eine geschlossene Auflagefläche für die erste stirnseitige Elektrode 16. Gleiches gilt für die zweiten Stirnflächen 15 und die daran angrenzenden Rand- und Hauptelektroden 18, 19 aller Kristallelemente 11, die eine geschlossene Auflagefläche für die zweite stirnseitige Elektrode 17 bilden.

Die Kristallelemente 11 weisen somit zwischen den beiden gegenüberliegenden Stirnflächen 24, 25, die der Krafteinleitung dienen, einen im Wesentlichen einheitlichen Querschnitt auf, der nicht - wie beim Stand der Technik - durch eine stirnseitige Ausbildung von Rundungen und Fasen an den Kanten der Kristallelemente 11 geschwächt ist.

Bei der Ausführungsvariante gemäß Fig. 1 und Fig. 2 können die stirnseitigen Elektroden 16, 17 in einer Dicke von 1 µm bis 20 µm, vorzugsweise von 2 µm bis 4 µm, ausgeführt sein und dienen zumindest bei der Montage des Messelementstapels 10, beispielsweise in einem Drucksensor, für den Zusammenhalt der Kristallelemente 11. Eine feste Verbindung der seitlichen Ableitelektroden 12 durch Löten oder Bonden ist daher bei dieser Variante nicht erforderlich.

Wie in Fig. 2 angedeutet können die isolierenden Bereiche 20 benachbarter Ableitelektroden 12 aufgrund herstellungsbedingter Unterschiede in der Länge oder der Beschichtung einzelner Kristallelemente 11 geringfügig zueinander versetzt angeordnet sein. Es muss lediglich dafür gesorgt sein, dass ein elektrischer Kontakt zwischen der Randelektrode 18 eines Kristallelements 11 und der Hauptelektrode 19 des benachbarten Kristallelements 11 unterbunden bleibt. Das vereinfacht die Herstellung der mit Ableitelektroden 12 beschichteten Kristallelemente 11, da lediglich die der Krafteinleitung dienenden Stirnflächen 24, 25 gemeinsam bearbeitet werden müssen, um die planparallelen Krafteinleitflächen ε1, ε2 auszubilden. Bei der gemeinsamen Bearbeitung werden die Kristallelemente 11 durch eine von außen - im Wesentlichen normal auf die Seitenflächen 13 der Kristallelemente 11 - angreifende Spanneinrichtung (siehe Pfeile 23 in Fig. 2) zusammengehalten bzw. fixiert.

Der streifenförmige elektrisch isolierende Bereich 20 kann durch entsprechende Maskierung bei der Aufbringung der Ableitelektrode 12, beispielsweise durch Sputtern, Aufdampfen oder Vacuum Deposition hergestellt werden.

Es ist auch möglich, den elektrisch isolierenden Bereich 20 durch nachträgliches Ätzen, Fräsen, Schleifen oder durch Laserablation der Ableitelektrode 12 herzustellen, wobei darauf geachtet werden muss, die Seitenflächen 13 des Kristallelements 11 schonend zu behandeln.

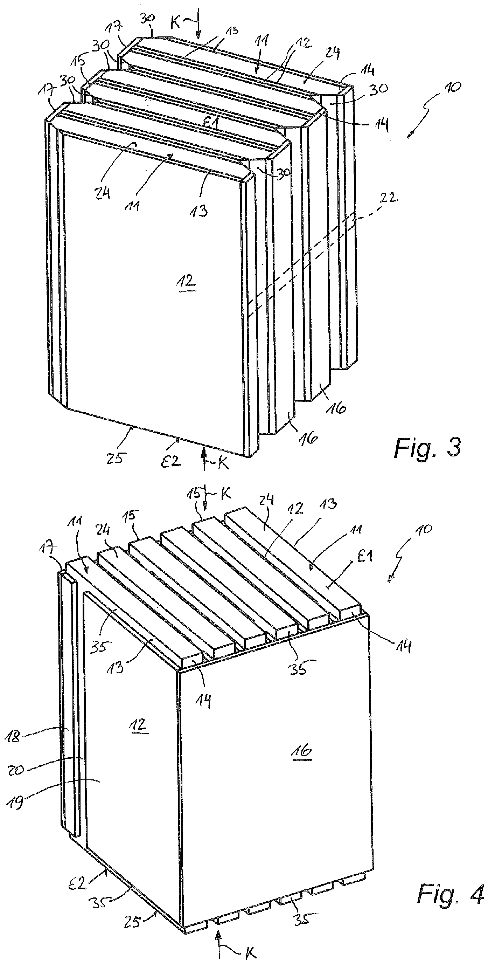

Bei der in Fig. 3 dargestellten Ausführungsvariante weist jede Ableitelektrode 12 einen elektrisch isolierenden Bereich 30, beispielsweise in Form einer randseitigen Fase oder Ausnehmung auf, wobei ein isolierender Bereich 30 des Kristallelements 11 an dessen erste Stirnfläche 14 und der andere isolierende Bereich 30 an dessen zweite Stirnfläche 15 angrenzt und die isolierenden Bereiche 30 benachbarter Ableitelektroden 12 im Messelementstapel 10 einander zugekehrt angeordnet sind.

Bei der hier dargestellten Ausführungsvariante können die einzelnen Kristallelemente 11 des Stapels 10 mit Hilfe der anderen Seitenflächen 13 angeordneten Ableitelektroden 12 durch Bonden, Löten oder Thermokompression fest miteinander verbunden sein. Die stirnseitigen Elektroden 16 und 17 sind hier in mehrere Teilelektroden unterteilt und werden beim Einbau - wie strichliert mittels seitlicher Elektrode 22 angedeutet - elektrisch leitend verbunden.

Bei der Ausführungsvariante gemäß Fig. 4 weist jede Ableitelektrode 12 sowie die stirnseitigen Elektroden 16, 17 angrenzend an die für die Krafteinleitung vorgesehenen dritten und vierten Stirnflächen 24, 25 der Kristallelemente 11 eine elektrisch isolierende Freistellung 35 auf und ist so für den potentialfreien Einbau in einen Drucksensor geeignet.

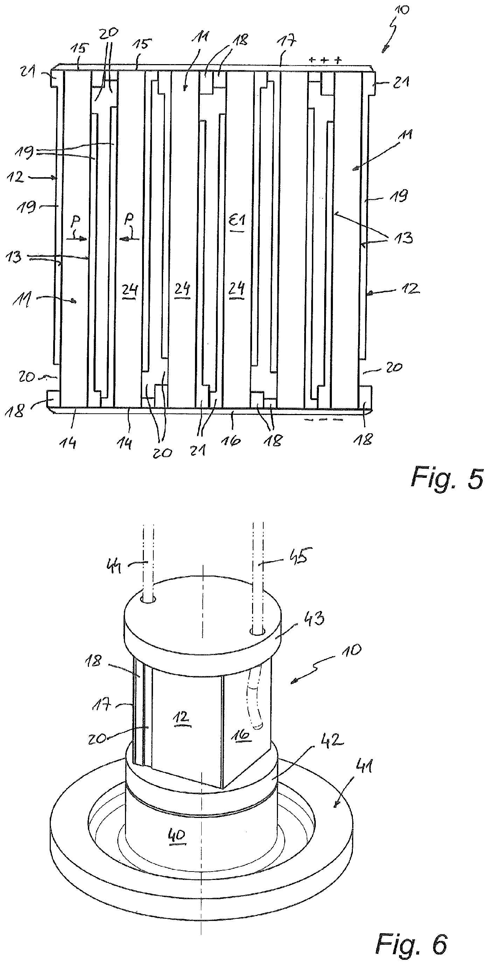

Die in Fig. 5 dargestellte Ausführungsvariante der Erfindung unterscheidet sich von jener nach Fig. 1 und Fig. 2 dadurch, dass die Randelektrode 18 und der stirnseitige Randbereich 21 der Hauptelektrode 19 eine größere Materialdicke, beispielsweise die doppelte Materialdicke, als der verbleibende Teil der Hauptelektrode 19 aufweisen (überhöht dargestellt), sodass benachbarten Ableitelektroden 12 im Messelementstapel 10 - bis auf die beiden stirnseitigen Bereiche - voneinander beabstandet sind (siehe Fig. 5). Durch diese Maßnahme kann ein Kontakt benachbarter Ableitelektroden 12 im Messbetrieb selbst bei hoher Temperatur und hohen Kräften bzw. raschen Lastwechseln weitgehend ausgeschlossen werden.

Die Herstellung eines Messelementstapels gemäß Fig. 5 verläuft im Wesentlichen analog dem bereits beschriebenen Herstellungsverfahren eines Stapels gemäß Fig. 1 und Fig. 2, wobei lediglich die stirnseitigen Randelektroden 18 und ein stirnseitiger Randbereich 21 der Hauptelektroden 19 mit größerer Materialdicke ausgeführt werden, als der verbleibende Teil der Hauptelektroden 19.

In Fig. 6 ist die Einbausituation eines erfindungsgemäßen Messelementstapels 10 dargestellt, der zwischen dem Druckstempel 40 einer Sensormembran 41 und einem Gegenlager eines nicht weiter dargestellten Drucksensors eingespannt ist. Zur elektrischen Isolierung des Messelementstapels 10 gegenüber den anliegenden, elektrisch leitenden Teilen des Drucksensors sind isolierende Auflagen 42, 43, beispielsweise aus Keramik, vorgesehen. Die Auflage 43 wird von elektrischen Leitern 44, 45 durchsetzt, die die stirnseitigen Elektroden 16 und 17 des Messelementstapels 10 kontaktieren.

Bei einem Drucksensor mit einer beispielsweise keramischen Sensormembran 41 sowie einem elektrisch isolierenden Gegenlager (z.B. ebenfalls aus Keramik) können die Auflagen 42 und 43 entfallen, sodass ein kompakter Aufbau des Sensors gewährleistet ist.

Die isolierenden Auflagen 42, 43 können selbst bei einem Drucksensor mit Metallgehäuse und elektrisch leitendem Membranmaterial entfallen, wenn ein Messelementstapel 10 gemäß Fig. 4 eingesetzt wird, der auf beiden Seiten des Stapels elektrisch isolierende Freistellungen 35 aufweist.

Die Messgenauigkeit des erfindungsgemäßen Messelementstapels 10 wird erhöht, da die der Krafteinleitung dienenden Flächen ε1 und ε2 (siehe Fig. 4, Fig. 5) in einem Arbeitsgang gemeinsam hergestellt werden können.

## Patentansprüche

1. Messelementstapel (10) zum Messen von Kräften oder Drücken aus mehreren piezoelektrischen Kristallelementen (11), die unter Nutzung des transversalen Piezoeffektes mit jeweils entgegengerichteter elektrischer Polarisation gestapelt sind, die gegenüberliegende erste und zweite Stirnflächen (14, 15) sowie gegenüberliegende dritte und vierte Stirnflächen (24, 25) und parallele Seitenflächen (13) mit Ableitelektroden (12) aufweisen, wobei an den gegenüberliegenden ersten und zweiten Stirnflächen (14, 15) erste und zweite stirnseitige Elektroden (16, 17) angeordnet sind, **dadurch gekennzeichnet, dass** die gegenüberliegenden dritten und vierten Stirnflächen (24, 25), die auf den Seitenflächen (13) im Wesentlichen normal stehen, als planparallele Krafteinleitflächen (ε1, ε2) ausgebildet sind, wobei jede Ableitelektrode (12) einen elektrisch isolierenden Bereich (20, 30) aufweist.

2. Messelementstapel (10) nach Anspruch 1, **dadurch gekennzeichnet, dass** jede Ableitelektrode (12) durch den elektrisch isolierenden Bereich (20) in eine kleinere, an eine der beiden Stirnflächen (14, 15) angrenzende Randelektrode (18) und eine größere Hauptelektrode (19) unterteilt ist, wobei eine der Hauptelektroden (19) des Kristallelements (11) an dessen erste Stirnfläche (14) angrenzt und die erste stirnseitige Elektrode (16) kontaktiert und die andere Hauptelektrode (19) an dessen zweite Stirnfläche (15) angrenzt und die zweite stirnseitige Elektrode (17) kontaktiert und wobei die Randelektroden (18) benachbarter Ableitelektroden (12) aneinander anliegen.

3. Messelementstapel (10) nach Anspruch 2, **dadurch gekennzeichnet, dass** die ersten Stirnflächen (14) und die daran angrenzenden Rand- und Hauptelektroden (18, 19) aller Kristallelemente (11) des Messelementstapels (10) eine geschlossene Auflagefläche für die erste stirnseitige Elektrode (16) bilden, sowie dass die zweiten Stirnflächen (15) und die daran angrenzenden Rand- und Hauptelektroden (18, 19) aller Kristallelemente (11) eine geschlossene Auflagefläche für die zweite stirnseitige Elektrode (17) bilden.

4. Messelementstapel (10) nach einem der Ansprüche 1 bis 3, **dadurch gekennzeichnet, dass** die Randelektrode (18) und der stirnseitige Randbereich (21) der Hauptelektrode (19) eine größere Materialdicke, beispielsweise die doppelte Materialdicke, als der verbleibende Teil der Hauptelektrode (19) aufweisen, sodass benachbarte Ableitelektroden (12) im Messelementstapel (10) - bis auf die beiden stirnseitigen Bereiche - voneinander beabstandet sind.

5. Messelementstapel (10) nach einem der Ansprüche 1 bis 4, **dadurch gekennzeichnet, dass** die stirnseitigen Elektroden (16, 17) in einer Dicke von 1 µm bis 20 µm, vorzugsweise von 2 µm bis 4 µm, ausgeführt sind und zumindest bei der Montage des Messelementstapels (10) für den seitlichen Zusammenhalt der Kristallelemente (11) dienen.

6. Messelementstapel (10) nach Anspruch 1, **dadurch gekennzeichnet, dass** der elektrisch isolierenden Bereich (30) jeder Ableitelektrode (12) beispielsweise in Form einer randseitigen Fase oder Ausnehmung vorgesehen ist, wobei ein isolierender Bereich (30) des Kristallelements (11) an dessen erste Stirnfläche (14) und der andere isolierende Bereich (30) an dessen zweite Stirnfläche (15) angrenzt und die isolierenden Bereiche (30) benachbarter Ableitelektroden (12) im Messelementstapel (10) einander zugekehrt angeordnet sind.

7. Messelementstapel (10) nach Anspruch 6, **dadurch gekennzeichnet, dass** die einzelnen Kristallelemente (11) mit Hilfe der Ableitelektroden (12) an deren Seitenflächen (13) durch Bonden, Löten oder Thermokompression fest miteinander verbunden sind.

8. Messelementstapel (10) nach einem der Ansprüche 1 bis 7, **dadurch gekennzeichnet, dass** jede Ableitelektrode (12) angrenzend an zumindest eine der für die Krafteinleitung vorgesehenen dritten und vierten Stirnflächen (24, 25) der Kristallelemente (11) eine elektrisch isolierende Freistellung (35) aufweist.

9. Messelementstapel (10) nach einem der Ansprüche 2 bis 8, **dadurch gekennzeichnet, dass** die isolierenden Bereiche (20, 30) benachbarter Ableitelektroden (12) spiegelgleich oder geringfügig zueinander versetzt angeordnet sind, derart, dass ein elektrischer Kontakt zwischen Elektroden unterschiedlicher Polarität im Überlappungsbereich unterbunden ist.

10. Messelementstapel (10) nach einem der Ansprüche 1 bis 9, **dadurch gekennzeichnet, dass** die Kristallelemente (11) zwischen den beiden der Krafteinleitung dienenden, gegenüberliegenden Stirnflächen (24, 25) einen im Wesentlichen einheitlichen Querschnitt aufweisen, ohne stirnseitige Ausbildung von Rundungen und Fasen an den Kanten.

11. Verfahren zur Herstellung eines Messelementstapels (10) zum Messen von Kräften oder Drücken aus mehreren piezoelektrischen Kristallelementen (11), die unter Nutzung des transversalen Piezoeffektes mit jeweils entgegengerichteter elektrischer Polarisation gestapelt werden, **gekennzeichnet durch** folgende Schritte:
a. Bereitstellung von im Wesentlichen quaderförmigen Kristallelementen (11) mit parallelen Seitenflächen (13), gegenüberliegenden ersten und zweiten Stirnflächen (14, 15) sowie gegenüberliegenden dritten und vierten Stirnflächen (24, 25) mit Rohabmessungen;
b. Aufbringen von Ableitelektroden (12) auf beide Seitenflächen (13), wobei jeweils elektrisch isolierende Bereiche (20, 30) im Bereich einer der ersten und zweiten Stirnflächen (14, 15) hergestellt werden, wobei die beiden isolierenden Bereiche (20, 30) unterschiedlichen ersten und zweiten Stirnflächen (14, 15) des Kristallelements (11) zugeordnet sind;
c. Aneinanderreihen mehrerer Kristallelemente (11) zu einem Messelementstapel (10), so dass die isolierenden Bereiche (20, 30) benachbarter Ableitelektroden (12) aneinander anliegen;
d. Fixierung der Kristallelemente (11) durch eine von außen angreifende Spanneinrichtung;
e. jeweils gemeinsame Bearbeitung der dritten (24) und der vierten Stirnflächen (25) der Kristallelemente (11) in der Spanneinrichtung durch Schleifen und oder Läppen zur Abtragung von Längenunterschieden einzelner Kristallelemente (11) und zur Herstellung von zwei gegenüberliegenden, im Wesentlichen planparallelen Auflageflächen (ε1, ε2);
f. Aufbringen einer ersten stirnseitigen Elektrode (16) auf eine durch die ersten Stirnflächen (14) gebildete, erste Auflagefläche und einer zweiten stirnseitigen Elektrode (17) auf eine durch die zweiten Stirnflächen (15) gebildete, zweite Auflagefläche, sowie
g. Entfernen der Spanneinrichtung vom Messelementstapel (10).

12. Verfahren nach Anspruch 11, **dadurch gekennzeichnet, dass** im Schritt b. die Ableitelektroden (12) jeweils durch den elektrisch isolierenden Bereich (20) in eine kleinere, an eine der beiden Stirnflächen (14, 15) angrenzende Randelektrode (18) und eine größere Hauptelektrode (19) unterteilt werden.

13. Verfahren nach Anspruch 12, **dadurch gekennzeichnet, dass** anschließend an Schritt b. oder im Schritt b. die stirnseitige Randelektrode (18) und ein stirnseitiger Randbereich (21) der Hauptelektrode (19) mit größerer Materialdicke ausgeführt werden, als der verbleibende Teil der Hauptelektrode (19).

## Claims

1. Measuring element stack (10) for measuring forces or pressures, made from a plurality of piezoelectric crystal elements (11) which by using the transverse piezoelectric effect are stacked with in each case oppositely directed electrical polarization and which have opposite first and second end faces (14, 15) and opposite third and fourth end faces (24, 25) and parallel side faces (13) with discharge electrodes (12), wherein first and second end face electrodes (16, 17) are arranged on opposite first and second end faces (14, 15), **characterised in that** the opposite third and fourth end faces (24, 25), which are substantially normal on the side faces (13), are designed as plane-parallel force introduction surfaces (ε1, ε2), wherein each discharge electrode (12) has an electrically insulating region (20, 30).

2. Measuring element stack (10) according to claim 1, **characterised in that** each discharge electrode (12) is divided by the electrically insulating region (20) into a smaller edge electrode (18) adjoining one of the two end faces (14, 15) and a larger main electrode (19), wherein one of the main electrodes (19) of the crystal element (11) adjoins its first end face (14) and contacts the first end face electrode (16) and the other main electrode (19) adjoins its second end face (15) and contacts the second end face electrode (17), and wherein the edge electrodes (18) of adjacent discharge electrodes (12) abut one another.

3. Measuring element stack (10) according to claim 1 or 2, **characterised in that** the first end faces (14) and the edge and main electrodes (18, 19) of all crystal elements (11) of the measuring element stack (10) adjoining said first end faces form a closed bearing surface for the first end face electrode (16), and **in that** the second end faces (15) and the edge and main electrodes (18, 19) of all crystal elements (11) adjoining said second end faces form a closed bearing surface for the second end face electrode (17).

4. Measuring element stack (10) according to one of claims 1 to 3, **characterised in that** the edge electrode (18) and the end face edge region (21) of the main electrode (19) have a greater material thickness, for example twice the material thickness, than the remaining part of the main electrode (19), so that adjacent discharge electrodes (12) in the measuring element stack (10) are spaced apart from one another - except for the two end face regions.

5. Measuring element stack (10) according to one of claims 1 to 4, **characterised in that** the end face electrodes (16, 17) are designed in a thickness of 1 µm to 20 µm, preferably of 2 µm to 4 µm, and serve at least during the assembly of the measuring element stack (10) for the lateral cohesion of the crystal elements (11).

6. Measuring element stack (10) according to claim 1, **characterised in that** the electrically insulating region (30) of each discharge electrode (12) is provided, for example, in the form of a chamfer or recess at the edge, wherein an insulating region (30) of the crystal element (11) adjoins its first end face (14) and the other insulating region (30) adjoins its second end face (15), and the insulating regions (30) of adjacent discharge electrodes (12) in the measuring element stack (10) are arranged facing one another.

7. Measuring element stack (10) according to claim 6, **characterised in that** the individual crystal elements (11) are firmly connected to one another with the aid of the discharge electrodes (12) on their side surfaces (13) by bonding, soldering or thermocompression.

8. Measuring element stack (10) according to one of claims 1 to 7, **characterised in that** each discharge electrode (12) has an electrically insulating cut-out (35) adjacent to at least one of the third and fourth end faces (24, 25) of the crystal elements (11) provided for the introduction of force.

9. Measuring element stack (10) according to one of claims 2 to 8, **characterised in that** the insulating regions (20, 30) of adjacent discharge electrodes (12) are arranged mirror-inverted or slightly offset with respect to one another in such a way that an electrical contact between electrodes of different polarity in the overlapping region is prevented.

10. Measuring element stack (10) according to one of claims 1 to 9, **characterised in that** the crystal elements (11) have a substantially uniform cross-section between the two opposing end faces (24, 25) serving to introduce the force, without the formation on the end faces of rounded portions and chamfers at the edges.

11. Method for producing a measuring element stack (10) for measuring forces or pressures, made from a plurality of piezoelectric crystal elements (11) which are stacked by using the transverse piezoelectric effect with opposite electric polarization in each case, **characterised by** the following steps:
a. providing substantially parallelepipedal crystal elements (11) having parallel side faces (13) and opposite first and second end faces (14, 15) and opposite third and fourth end faces (24, 25) having raw dimensions;
b. applying discharge electrodes (12) to both side surfaces (13), wherein electrically insulating regions (20, 30) are produced in each case in the region of one of the first and second end faces (14, 15), wherein the two insulating regions (20, 30) are assigned to different first and second end faces (14, 15) of the crystal element (11);
c. lining up a plurality of crystal elements (11) one after the other to form a measuring element stack (10), so that the insulating regions (20, 30) of adjacent discharge electrodes (12) abut one another;
d. fixing the crystal elements (11) by an externally acting clamping device;
e. in each case jointly machining the third (24) and the fourth end faces (25) of the crystal elements (11) in the clamping device by grinding and/or lapping for removing length differences of individual crystal elements (11) and for producing two opposing, substantially plane-parallel bearing surfaces (ε1, ε2);
f. applying a first end face electrode (16) to a first bearing surface formed by the first end faces (14) and a second end face electrode (17) to a second bearing surface formed by the second end faces (15), and
g. removing the clamping device from the measuring element stack (10).

12. Method according to claim 11, **characterised in that** in step b) the discharge electrodes (12) are each divided by the electrically insulating region (20) into a smaller edge electrode (18) adjoining one of the two end faces (14, 15) and a larger main electrode (19).

13. Method according to claim 12, **characterised in that,** following step b) or in step b), the end face edge electrode (18) and an end face edge region (21) of the main electrode (19) are formed with greater material thickness than the remaining part of the main electrode (19).

## Revendications

1. Empilement d'éléments de mesure (10) permettant de mesurer des forces ou des pressions constitué par plusieurs éléments cristallins piézoélectriques (11) empilés, en utilisant l'effet piézoélectrique transversal avec des polarisations électriques respectivement dirigées en sens inverse, comportant chacun une première face frontale et une seconde face frontale (14, 15) opposées l'une à l'autre ainsi qu'une troisième face frontale et une quatrième face frontale (24, 25) opposées l'une à l'autre et des faces latérales (13) parallèles, équipées d'électrodes de référence (12), sur la première face frontale et la seconde face frontale (14, 15) opposées l'une à l'autre étant montées une première électrode frontale et une seconde électrode frontale (16, 17),
**caractérisé en ce que**
la troisième face frontale et la quatrième face frontale (24, 25) opposées l'une à l'autre qui sont essentiellement perpendiculaires aux face latérales (13) sont réalisées sous la forme de faces d'introduction des forces planes et parallèles (ε1, ε2), chacune des électrodes de référence (12) comprenant une zone électriquement isolante (20, 30).

2. Empilement d'éléments de mesure (10) conforme à la revendication 1,
**caractérisé en ce que**
chaque électrode de référence (12) est subdivisée par la zone électriquement isolante (20) en une électrode de bord (18) plus petite adjacente à l'une des deux faces frontales (14, 15) et une électrode principale (19) plus grande, l'une des électrodes principales (19) de l'élément cristallin (11) étant adjacente à la première face frontale (14) et venant en contact avec la première électrode frontale (16) et l'autre électrode principale (19) étant adjacente à la seconde face frontale (15) et venant en contact avec la seconde électrode frontale (17), et les électrodes de bord (18) d'électrodes de référence (12) voisines étant appliquées l'une sur l'autre.

3. Empilement d'éléments de mesure (10) conforme à la revendication 2,
**caractérisé en ce que**
les premières faces frontales (14) et les électrodes de bord et les électrodes principales (18, 19) adjacentes à celles-ci de tous les éléments cristallins (11) de l'empilement d'éléments de mesure (10) forment une surface d'appui fermée pour la première électrode frontale (16) et les secondes faces frontales (15) et les électrodes de bord et les électrodes principales (18, 19) adjacentes à celles-ci de tous les éléments cristallins (11) forment une surface d'appui fermée pour la seconde électrode frontale (17).

4. Empilement d'éléments de mesure (10) conforme à l'une des revendications 1 à 3,
**caractérisé en ce que**
l'électrode de bord (18) et la zone de bord frontale (21) de l'électrode principale (19) ont une plus grande épaisseur de matériau, par exemple égale au double de l'épaisseur de la partie restante de l'électrode principale (19) de sorte que des électrodes de référence (12) voisines dans l'empilement d'éléments de mesure (10) soient situées à distance jusqu'aux deux zones frontales.

5. Empilement d'éléments de mesure (10) conforme à l'une des revendications 1 à 4,
**caractérisé en ce que**
les électrodes frontales (16, 17) sont réalisées avec une épaisseur de 1µm à 20µm, de préférence de 2µm à 4 µm, et, servent au moins lors du montage de l'empilement d'éléments de mesure (10) au maintien latéral des éléments cristallins (11).

6. Empilement d'éléments de mesure (10) conforme à la revendication 1,
**caractérisé en ce que**
la zone électriquement isolante (30) de chaque élément de référence (12) est par exemple prévue sous la forme d'un chanfrein ou d'un évidement circulaire, et une zone isolante (30) de l'élément cristallin (11) est adjacente à sa première face frontale (14) et l'autre zone isolante (30) est adjacente à sa seconde face frontale (15) et les zones isolantes (30) d'électrodes de référence (12) voisines dans l'empilement d'éléments de mesure (10) sont opposées.

7. Empilement d'éléments de mesure (10) conforme à la revendication 6,
**caractérisé en ce que**
les éléments cristallins individuels (11) sont reliés solidairement à l'aide des électrodes de référence (12) sur leurs faces frontales (13) par collage, soudure ou thermocompression.

8. Empilement d'éléments de mesure (10) conforme à l'une des revendications 1 à 7,
**caractérisé en ce que**
chaque électrode de référence (12) comporte un congé (35) électriquement isolant adjacent à la troisième et/ou à la quatrième face frontale (24, 25) de l'élément cristallin (11) prévue(s) pour l'introduction de force.

9. Empilement d'éléments de mesure (10) conforme à l'une des revendications 2 à 8,
**caractérisé en ce que**
les zones isolantes (20, 30) d'électrodes de référence voisines (12) sont présentent une symétrie de miroir ou sont un peu décalées de façon à empêcher un contact électrique entre des électrodes de polarité différente dans la zone de chevauchement.

10. Empilement d'éléments de mesure (10) conforme l'une des revendications 1 à 9,
**caractérisé en ce que**
les éléments cristallins (11) ont, entre les deux faces frontales opposées (24, 25) servant à l'introduction des forces, une section essentiellement unitaire sans formation d'arrondis et de biseaux au niveau des arêtes.

11. Procédé de fabrication d'un empilement d'éléments de mesure (10) permettant de mesurer des forces ou des pressions constitué de plusieurs éléments cristallins piézoélectriques (11) empilés, en utilisant l'effet piézoélectrique transversal avec des polarisations électriques respectivement dirigées en sens inverse,
**caractérisé en ce qu'**il comporte les étapes suivantes consistant à :
a. se procurer des éléments cristallins de forme essentiellement parallélépipédiques (11) ayant des faces latérales (13) parallèles, une première et une seconde face frontale (14, 15) opposées ainsi qu'une troisième et une quatrième face frontale (24, 25) opposées, ayant des dimensions brutes,
b. appliquer des électrodes de référence (12) sur les deux faces latérales (13), des zones électriquement isolantes respectives (20, 30) étant respectivement formées dans la zone de la première ou de la seconde face frontale (14, 15), les deux zones isolantes (20, 30) étant associées à une première et à une seconde face frontale différente (14, 15) de l'élément cristallin (11),
c. aligner plusieurs éléments cristallins (11) en un empilement d'éléments de mesure (10) de sorte que les zones isolantes (20, 30) d'électrodes de référence (12) voisines soient appliquées l'une sur l'autre,
d. fixer les éléments cristallins (11) par un dispositif de serrage venant en prise par l'extérieur,
e. usiner respectivement, conjointement la troisième face frontale (24) et la quatrième face frontale (25) des éléments cristallins (11) dans le dispositif de serrage par rectification et/ou rodage pour éliminer des différences de longueur d'éléments cristallins (11) individuels et pour obtenir deux surfaces d'appui opposées essentiellement parallèles et planes (ε1, ε2),
f. appliquer une première électrode frontale (16) sur une première face d'appui formée par la première face frontale (14) et une seconde électrode frontale (17) sur une seconde face d'appui formée par la seconde face frontale (15), et
g. enlever le dispositif de serrage de l'empilement d'éléments de mesure (10).

12. Procédé conforme à la revendication 11,
**caractérisé en ce que**
lors de l'étape b les électrodes de référence (12) sont respectivement subdivisées par la zone électriquement isolante (20) en une électrode de bord (18) plus petite adjacente à l'une des deux faces frontales (14, 15) et en une électrode principale (19) plus grande.

13. Procédé conforme à la revendication 12,
**caractérisé en ce qu'**
à la suite de l'étape b ou lors de l'étape b l'électrode de bord frontale (18) et une zone de bord frontale (21) de l'électrode principale (19) sont réalisées avec une plus grande épaisseur de matériau que celle de la partie restante de l'électrode principale (19).
